# EUROPEAN PATENT APPLICATION

(11) **EP 4 822 581 A1**
(43) Date of publication of application: **14.10.2026**
(21) Application number: 24899262.0
(22) Date of filing: 16.07.2024
(51) Int. Cl.: G06F 30/20

(54) **CARBON FOOTPRINT ACCOUNTING METHOD AND SYSTEM FOR POWER GRID MATERIAL PRODUCT BASED ON LCA**

(30) Priority: 08.12.2023 CN 202311684397
(71) Applicant: Yunnan Power Grid Co., Ltd. Digital Intelligence Operations Center, Kunming, Yunnan 650041 (CN); Yunnan Electric Power Test and Research Institute (Group) Co., Ltd, Kunming, Yunnan 650214 (CN)
(72) Inventor: LI, Shenzhang, Kunming, Yunnan 650041 (CN); ZHAO, Zhiyu, Kunming, Yunnan 650041 (CN); LI, Hui, Kunming, Yunnan 650041 (CN); MAO, Zhengxiong, Kunming, Yunnan 650041 (CN); XIAO, Peng, Kunming, Yunnan 650041 (CN); DING, Xinzhi, Kunming, Yunnan 650041 (CN); GENG, Zhenwei, Kunming, Yunnan 650041 (CN); ZHAO, Xiaoping, Kunming, Yunnan 650041 (CN); LUO, Zhenyu, Kunming, Yunnan 650041 (CN)
(74) Representative: Osterhoff, Utz
(86) International application number: PCT/CN2024/105777
(87) International publication number: WO 2025/118611

(57) **Abstract**

The present application discloses a carbon footprint accounting method and a system for power grid material product based on LCA, relating to the technical field of carbon footprint accounting. The method includes: establishing a product carbon footprint model for the power grid material product based on a LCA method; collecting data for the power grid material product, and accounting carbon emissions for the power grid material product in each stage from raw material acquisition to scrap and recycling according to the collected data; selecting power carbon emission factors of different grades for each stage in the carbon footprint accounting to account power carbon emissions; and completing high-precision real-time carbon footprint accounting of an entire life cycle for the power grid material product in combination with the accounted data. The method enables more accurate assessment of the environmental impact of product. Meanwhile, real-time accounting can timely reflect the effects of any changes or improvements. Through comprehensive carbon footprint analysis, detailed carbon footprint accounting can identify high-emission activities, provide data support for the optimization of product design and production processes, and help reduce overall carbon emissions.

## Description

### TECHNICAL FIELD

The present application relates to the technical field of carbon footprint accounting, and in particular to a carbon footprint accounting method and a carbon footprint accounting system for power grid material product based on LCA.

### BACKGROUND

With global warming and the proposal of carbon neutrality goals, higher requirements have been put forward for reducing carbon emissions. As a high-carbon emission industry, the power industry is actively promoting green and low-carbon development. As core materials and equipment of power grids, power grid material product generate considerable carbon emissions during their production and use. However, in the process of carbon footprint accounting and analysis for power grid material product, the selection of power carbon emission factors usually adopts national emission factors for carbon verification or power carbon footprint values from international general background databases, resulting in insufficient accuracy in carbon footprint accounting and analysis for power grid material product. This lacks data support for green transformation of enterprises, fails to meet requirements such as green procurement of power grids, and is not conducive to promoting the low-carbon development of the entire power industry and its upstream and downstream enterprises.

Life cycle assessment (LCA) is a method used to assess the environmental impacts of a product, process or service throughout its life cycle (i.e., from raw material extraction and processing to the use, recycling or disposal of the final product). The main purpose of LCA is to identify and quantify energy use, resource consumption and environmental emissions during the life cycle of a product or service.

### SUMMARY

In view of the above problems, the present application is provided.

Therefore, the problem to be solved by the present application is: how to solve the problem of accounting the carbon footprint for power grid material product.

To solve the above technical problems, the present application provides the following technical solution: a carbon footprint accounting method for power grid material product based on LCA, including:
establishing a product carbon footprint model for the power grid material product based on a LCA method;
collecting data for the power grid material product, and accounting carbon emissions for the power grid material product in each stage from raw material acquisition to scrap and recycling according to the collected data;
selecting power carbon emission factors of different grades for each stage in the carbon footprint accounting to account power carbon emissions;
completing high-precision real-time carbon footprint accounting of an entire life cycle for the power grid material product in combination with the accounted data.

As a preferred solution of the carbon footprint accounting method for power grid material product based on LCA according to the present application, where: the product carbon footprint model includes stages of raw material acquisition, transportation, production and manufacturing, product transportation and delivery, product use and scrap and recycling; and
the data for the power grid material product include raw material dosage, composition, transportation distance, energy consumption information for the power grid material product, and energy consumption and gas emission data during production.

As a preferred solution of the carbon footprint accounting method for power grid material product based on LCA according to the present application, where: the carbon emissions in each stage include carbon emissions in the raw material acquisition stage, carbon emissions in the transportation stage, carbon emissions in the production and manufacturing stage, carbon emissions in the product transportation and delivery stage, carbon emissions in the product use stage and carbon emissions in the scrap and recycling stage; and
the carbon emissions in the raw material acquisition stage are expressed as:
   ${C}_{rm} = {\sum }_{i = 1}^{n} \left({Q}_{i}\times {EFC}_{i}+{IP}_{i}\right)$
   ${IP}_{i} = {R}_{i} \times {EFC}_{pmi}$
where *Cᵣₘ* is the carbon emissions in the raw material acquisition stage, *i* is an *i*-th raw material, *n* is a total type of raw materials, *Qᵢ* is a quantity of the *i*-th raw material, *EFCᵢ* is a direct carbon emission coefficient of the *i*-th raw material, *IPᵢ* is an indirect carbon emission of the *i*-th raw material, *Rᵢ* is energy required for production and processing of the *i*-th raw material, and *EFCₚₘᵢ* is a carbon emission coefficient of energy for production and processing of the *i*-th raw material; and
the carbon emissions in the transportation stage are expressed as:
   ${C}_{tr} = {\sum }_{j = 1}^{m} \left(\left({D}_{j}\times {TFC}_{j}\times {W}_{j}\right)+{IP}_{trj}\right)$
   ${IP}_{trj} = {E}_{trj} \times {EFC}_{trj}$
where *Cₜᵣ* is the carbon emissions in the transportation stage, *j* is a *j*-th transportation, *m* is a total number of transportation, *Dⱼ* is a distance of the *j*-th transportation, *TFCⱼ* is a carbon emission coefficient of the *j*-th transportation, *Wⱼ* is a cargo weight of the *j*-th transportation, *IPₜᵣⱼ* is an indirect carbon emission of the *j*-th transportation, *Eₜᵣⱼ* is an energy consumption of the *j*-th transportation, and *EFCₜᵣⱼ* is a carbon emission coefficient of energy for the *j*-th transportation.

As a preferred solution of the carbon footprint accounting method for power grid material product based on LCA according to the present application, where: the carbon emissions in the production and manufacturing stage are expressed as:
${C}_{man} = \left(EC\times {EFC}_{en}\right) + GP + {IP}_{man}$
${IP}_{max} = {\sum }_{k = 1}^{l} \left({E}_{{pd}_{k}}\times {EFC}_{{pe}_{k}}\right)$
where *Cₘₐₙ* is the carbon emissions in the production and manufacturing stage, *EC* is energy consumption during production, *EFCₑₙ* is a carbon emission coefficient of energy used, *GP* is a gas emission during production, *IPₘₐₙ* is an indirect carbon emission during production and manufacturing, *k* is a *k*-th production link, *l* is a total number of production links, *E_{pdₖ}* is energy consumption of the *k* -th production link, and *EFC_{peₖ}* is a carbon emission coefficient of energy for the *k*-th production link;
the carbon emissions in the product transportation and delivery stage are expressed as:
   ${C}_{td} = {D}_{td} \times {TFC}_{td} \times {W}_{td} + {IP}_{td}$
   ${IP}_{td} = {E}_{td} \times {EFC}_{td}$
where *C_{td}* is the carbon emissions in the product transportation and delivery stage, *D_{td}* is a transportation distance in the product transportation and delivery stage, *TFC_{td}* is a carbon emission coefficient of a transportation mode, *W_{td}* is a cargo weight, *IP_{td}* is an indirect carbon emission in the product transportation and delivery stage, *E_{td}* is other energy consumption during transportation, and *EFC_{td}* is a carbon emission coefficient of energy for other energy consumption activities;
the carbon emissions in the product use stage are expressed as:
   ${C}_{use} = \left(EU\times {EFC}_{en}\right) + {IP}_{use}$
   ${IP}_{use} = {EU}_{aux} \times {EFC}_{en}$
where *Cᵤₛₑ* is the carbon emissions in the product use stage, *EU* is energy consumption during product use, *IPᵤₛₑ* is an indirect carbon emission during use, and *EUₐᵤₓ* is energy consumption of auxiliary equipment during use; and
the carbon emissions in the scrap and recycling stage are expressed as:
   ${C}_{rec} = \left(\left({ED}_{rec}\times {EFC}_{en}\right)-SC\right) + {IP}_{rec}$
   ${IP}_{rec} = \left({E}_{pr}\times {EFC}_{pe}\right) - SR$
where *C_{rec}* is the carbon emissions in the scrap and recycling stage, *ED_{rec}* is energy consumption for treatment and transportation, *SC* is carbon emissions saved by recycling materials, *IP_{rec}* is an indirect carbon emission during scrap and recycling, *Eₚᵣ* is energy consumption for treatment and recycling, *EFCₚₑ* is a carbon emission coefficient of energy for treatment and recycling, and *SR* is carbon emissions reduced by recycling materials.

As a preferred solution of the carbon footprint accounting method for power grid material product based on LCA according to the present application, where: the power carbon emission factors include setting low, medium and high grade thresholds in each stage from raw material acquisition to scrap and recycling, and accounting the power carbon emission factors according to different grades;
in the raw material acquisition stage, in response to *Cᵣₘ*<*C_{rmL}*, the raw material acquisition stage is at low-grade carbon emission, and a low-grade power carbon emission factor in the raw material acquisition stage is expressed as:
   ${EFC}_{rmL} = \frac{{\sum }_{i = 1}^{n} \left({E}_{iL}\times {EFC}_{i}\right)}{{\sum }_{i = 1}^{n} {E}_{iL}}$
where *EFC_{rmL}* is a low-grade power carbon emission factor in the raw material acquisition stage, and *E_{iL}* is energy consumption of the *i*-th raw material at low grade;
in response to *C_{rmL}*<*Cᵣₘ*<*C_{rmH}*, the raw material acquisition stage is at medium-grade carbon emission, and a medium-grade power carbon emission factor in the raw material acquisition stage is expressed as:
   ${EFC}_{rmM} = \frac{{\sum }_{i = 1}^{n} \left({E}_{iM}\times {EFC}_{i}\right)}{{\sum }_{i = 1}^{n} {E}_{iM}}$
where *EFC_{rmM}* is a medium-grade power carbon emission factor in the raw material acquisition stage, and *E_{iM}* is the energy consumption of the *i*-th raw material at medium grade;
in response to *Cᵣₘ*>*C_{rmH}*, the raw material acquisition stage is at high-grade carbon emission, and a high-grade power carbon emission factor in the raw material acquisition stage is expressed as:
   ${EFC}_{rmH} = \frac{{\sum }_{i = 1}^{n} \left({E}_{iH}\times {EFC}_{i}\right)}{{\sum }_{i = 1}^{n} {E}_{iH}}$
where *EFC_{rmH}* is a high-grade power carbon emission factor in the raw material acquisition stage, and *E_{iH}* is energy consumption of the *i*-th raw material at high grade; and
power carbon emission factors of different grades are accounted respectively in the transportation stage, production and manufacturing stage, product transportation and delivery stage, product use stage and scrap and recycling stage, and power carbon emissions are accounted according to the power carbon emission factors of different grades in each stage and the carbon emissions in each stage.

As a preferred solution of the carbon footprint accounting method for power grid material product based on LCA according to the present application, where: the accounting of power carbon emissions includes accounting power carbon emissions in the stages of raw material acquisition, transportation, production and manufacturing, product transportation and delivery, product use and scrap and recycling according to the power carbon emission factors of each grade in each stage and the carbon emissions in each stage, and the power carbon emission is expressed as:
${CP}_{zx} = {EFC}_{zx} \times {C}_{z}$
where *CP_{zx}* is power carbon emissions of grade *x* in stage *z* , *EFC_{zx}* is a power carbon emission factor of grade *x* in stage *z* , and *C_{z}* is carbon emissions in stage *z* ..

As a preferred solution of the carbon footprint accounting method for power grid material product based on LCA according to the present application, where: the high-precision real-time carbon footprint accounting of the entire life cycle includes summing up the accounted carbon emissions of all stages to obtain the carbon footprint accounting of the entire product life cycle, and the carbon footprint accounting is expressed as:
$CP = {\sum }_{z = 1}^{6} {CP}_{zx}$
where *CP* is the carbon footprint accounting of the entire product life cycle;
in response to that *CP* is lower than a low threshold of the carbon footprint accounting of the entire product life cycle, an environmental impact of the product is within an acceptable range or excellent, and a current mode is maintained;
in response to that *CP* is between the low threshold and medium threshold of carbon footprint accounting of the entire product life cycle, it is indicated that the environmental impact of the product is at a general level, energy use and production process are reviewed, emission reduction potential is identified, and energy efficiency improvement measures are implemented;
in response to that *CP* is between the medium threshold and high threshold of the carbon footprint accounting of the entire product life cycle, focusing on high-emission activities, formulating specific emission reduction plans, investing in clean energy technologies, improving logistics and supply chain management, and reducing transportation emissions; and
in response to that *CP* exceeds the high threshold of carbon footprint accounting of the entire product life cycle, the environmental impact of the product is too high, strategic adjustment and improvement are carried out, the product is redesigned, and low-carbon technologies are adopted.

Another objective of the present application is to provide a system for implementing the carbon footprint accounting method for the power grid material product based on the LCA. By constructing a system for accounting the carbon footprint of power grid material products, the system solves the problem of accounting the carbon footprint of power grid material products based on LCA.

To solve the above technical problems, the present application provides the following technical solutions: a carbon footprint accounting system for the power grid material product based on the LCA, including: a data collection module, a carbon footprint model establishment module, a carbon emission accounting module, a power carbon emission factor accounting module and a power carbon emission accounting module. The data collection module collects all relevant data for power grid material product, including raw material dosage, composition, transportation distance, energy consumption information, as well as energy consumption and gas emission data during production. The carbon footprint model establishment module constructs a product carbon footprint model based on the collected data and the life cycle assessment method, covering all stages from raw material acquisition, transportation, production and manufacturing, product transportation and delivery, product use to scrap and recycling. The carbon emission accounting module accounts carbon emissions in each stage according to the carbon footprint model and the collected data. The power carbon emission factor accounting module accounts power carbon emission factors of different grades in each stage. The power carbon emission accounting module accounts power carbon emissions according to the power carbon emission factors of different grades in each stage and the carbon emissions in each stage.

A computer device, including a memory and a processor, where the memory stores a computer program, and the processor implements the steps of the carbon footprint accounting method for power grid material product based on LCA when executing the computer program.

A computer-readable storage medium storing a computer program, where the computer program implements the steps of the carbon footprint accounting method for power grid material product based on LCA when executed by a processor.

Beneficial effects of the present application are: the carbon footprint accounting method for power grid material product based on LCA provided by the present application accounts the carbon footprint for power grid material product throughout the entire life cycle from raw material acquisition to scrap and recycling, so as to more accurately assess the environmental impact of the product. At the same time, real-time accounting can timely reflect the effect of any changes or improvements. By analyzing energy consumption and carbon emissions in different stages, it helps to identify the potential of energy conservation and emission reduction, thus promoting more effective resource use and energy efficiency improvement. Through comprehensive carbon footprint analysis, the environmental impact in the product life cycle can be better understood and managed. Detailed carbon footprint accounting can reveal high-emission activities, provide data support for the optimization of product design and production process, and help reduce overall carbon emissions.

### BRIEF DESCRIPTION OF THE DRAWINGS

To more clearly illustrate the technical solutions of the embodiments of the present application, the drawings required in the description of the embodiments will be briefly introduced below. Obviously, the drawings in the following description are only some embodiments of the present application, and those skilled in the art can obtain other drawings according to these drawings without creative efforts.
FIG. 1 is an overall flow chart of a carbon footprint accounting method for power grid material product based on LCA provided by a first embodiment of the present application.
FIG. 2 is a structural diagram of a carbon footprint accounting system for power grid material product based on LCA provided by a second embodiment of the present application.

### DETAILED DESCRIPTION OF THE EMBODIMENTS

To make the above objectives, features and advantages of the present application more obvious and understandable, the specific embodiments of the present application will be described in detail below with reference to the specification drawings.

In the following description, many specific details are set forth to facilitate a full understanding of the present application, but the present application can also be implemented in other ways different from those described herein, and those skilled in the art can make similar promotion without violating the connotation of the present application, so the present application is not limited by the specific embodiments disclosed below.

### First embodiment

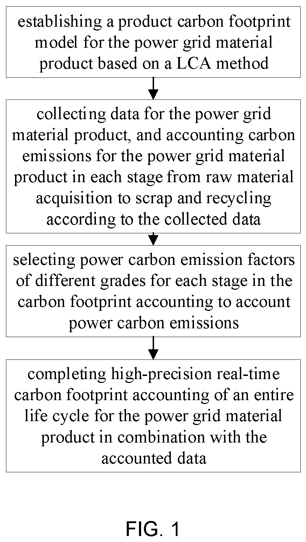

Referring to FIG. 1, this embodiment provides a carbon footprint accounting method for power grid material product based on LCA, including: establishing a product carbon footprint model for the power grid material product based on a LCA method; collecting data for the power grid material product, and accounting carbon emissions for the power grid material product in each stage from raw material acquisition to scrap and recycling according to the collected data; selecting power carbon emission factors of different grades for each stage in the carbon footprint accounting to account power carbon emissions; and completing high-precision real-time carbon footprint accounting of an entire life cycle for the power grid material product in combination with the accounted data.

The product carbon footprint model includes stages of raw material acquisition, transportation, production and manufacturing, product transportation and delivery, product use and scrap and recycling.

The data for power grid material product include raw material dosage, composition, transportation distance, energy consumption information for the power grid material product, and energy consumption and gas emission data during production.

The carbon emissions in each stage include carbon emissions in the raw material acquisition stage, carbon emissions in the transportation stage, carbon emissions in the production and manufacturing stage, carbon emissions in the product transportation and delivery stage, carbon emissions in the product use stage, and carbon emissions in the scrap and recycling stage.

The carbon emissions in the raw material acquisition stage are expressed as:
${C}_{rm} = {\sum }_{i = 1}^{n} \left({Q}_{i}\times {EFC}_{i}+{IP}_{i}\right)$
${IP}_{i} = {R}_{i} \times {EFC}_{pmi}$
where *Cᵣₘ* is the carbon emissions in the raw material acquisition stage, *i* is an *i*-th raw material, *n* is a total type of raw materials, *Qᵢ* is a quantity of the *i*-th raw material, *EFCᵢ* is a direct carbon emission coefficient of the *i*-th raw material, *IPᵢ* is an indirect carbon emission of the *i*-th raw material, *Rᵢ* is energy required for production and processing of the *i*-th raw material, and *EFCₚₘᵢ* is a carbon emission coefficient of energy for production and processing of the *i*-th raw material.

The carbon emissions in the transportation stage are expressed as:
${C}_{tr} = {\sum }_{j = 1}^{m} \left(\left({D}_{j}\times {TFC}_{j}\times {W}_{j}\right)+{IP}_{trj}\right)$
${IP}_{trj} = {E}_{trj} \times {EFC}_{trj}$
where *Cₜᵣ* is the carbon emissions in the transportation stage, *j* is a *j*-th transportation, *m* is a total number of transportation, *Dⱼ* is a distance of the *j*-th transportation, *TFCⱼ* is a carbon emission coefficient of the *j*-th transportation, *Wⱼ* is a cargo weight of the *j*-th transportation, *IPₜᵣⱼ* is an indirect carbon emission of the *j*-th transportation, *Eₜᵣⱼ* is an energy consumption of the *j*-th transportation, and *EFCₜᵣⱼ* is a carbon emission coefficient of energy for the *j*-th transportation.

The carbon emissions in the production and manufacturing stage are expressed as:
${C}_{man} = \left(EC\times {EFC}_{en}\right) + GP + {IP}_{man}$
${IP}_{man} = {\sum }_{k = 1}^{l} \left({E}_{{pd}_{k}}\times {EFC}_{{pe}_{k}}\right)$
where *Cₘₐₙ* is the carbon emissions in the production and manufacturing stage, *EC* is energy consumption during production, *EFCₑₙ* is a carbon emission coefficient of energy used, *GP* is a gas emission during production, *IPₘₐₙ* is an indirect carbon emission during production and manufacturing, *k* is a *k*-th production link, *l* is a total number of production links, *E_{pdₖ}* is energy consumption of the *k*-th production link, and *EFC_{peₖ}* is a carbon emission coefficient of energy for the *k*-th production link.

The carbon emissions in the product transportation and delivery stage are expressed as:
${C}_{td} = {D}_{td} \times {TFC}_{td} \times {W}_{td} + {IP}_{td}$
${IP}_{td} = {E}_{td} \times {EFC}_{td}$
where *C_{td}* is the carbon emissions in the product transportation and delivery stage, *D_{td}* is a transportation distance in the product transportation and delivery stage, *TFC_{td}* is a carbon emission coefficient of a transportation mode, *W_{td}* is a cargo weight, *IP_{td}* is an indirect carbon emission in the product transportation and delivery stage, *E_{td}* is other energy consumption during transportation, and *EFC_{td}* is a carbon emission coefficient of energy for other energy consumption activities.

The carbon emissions in the product use stage are expressed as:
${C}_{use} = \left(EU\times {EFC}_{en}\right) + {IP}_{use}$
${IP}_{use} = {EU}_{aux} \times {EFC}_{en}$
where *Cᵤₛₑ* is the carbon emissions in the product use stage, *EU* is energy consumption during product use, *IPᵤₛₑ* is an indirect carbon emission during use, and *EUₐᵤₓ* is energy consumption of auxiliary equipment during use.

The carbon emissions in the scrap and recycling stage are expressed as:
${C}_{rec} = \left(\left({ED}_{rec}\times {EFC}_{en}\right)-SC\right) + {IP}_{rec}$
${IP}_{rec} = \left({E}_{pr}\times {EFC}_{pe}\right) - SR$
where *C_{rec}* is the carbon emissions in the scrap and recycling stage, *ED_{rec}* is energy consumption for treatment and transportation, *SC* is carbon emissions saved by recycling materials, *IP_{rec}* is an indirect carbon emission during scrap and recycling, *Eₚᵣ* is energy consumption for treatment and recycling, *EFCₚₑ* is a carbon emission coefficient of energy for treatment and recycling, and *SR* is carbon emissions reduced by recycling materials.

Low, medium and high grade thresholds are set in each stage from raw material acquisition to scrap and recycling, and power carbon emission factors are accounted according to different grades; in the raw material acquisition stage, in response to *Cᵣₘ*<*C_{rmL}*, it is at low-grade carbon emission in the raw material acquisition stage, and a low-grade power carbon emission factor in the raw material acquisition stage is expressed as:
${EFC}_{rmL} = \frac{{\sum }_{i = 1}^{n} \left({E}_{iL}\times {EFC}_{i}\right)}{{\sum }_{i = 1}^{n} {E}_{iL}}$
where *EFC_{rmL}* is a low-grade power carbon emission factor in the raw material acquisition stage, and *E_{iL}* is energy consumption of the *i*-th raw material at low grade; in response to *C_{rmL}*<*Cᵣₘ*<*C_{rmH},* it is at medium-grade carbon emission in the raw material acquisition stage, and a medium-grade power carbon emission factor in the raw material acquisition stage is expressed as:
   ${EFC}_{rmM} = \frac{{\sum }_{i = 1}^{n} \left({E}_{iM}\times {EFC}_{i}\right)}{{\sum }_{i = 1}^{n} {E}_{iM}}$
where *EFC_{rmM}* is a medium-grade power carbon emission factor in the raw material acquisition stage, and *E_{iM}* is the energy consumption of the *i*-th raw material at medium grade; in response to *Cᵣₘ*>*C_{rmH},* it is at high-grade carbon emission in the raw material acquisition stage, and a high-grade power carbon emission factor in the raw material acquisition stage is expressed as:
   ${EFC}_{rmH} = \frac{{\sum }_{i = 1}^{n} \left({E}_{iH}\times {EFC}_{i}\right)}{{\sum }_{i = 1}^{n} {E}_{iH}}$
where *EFC_{rmH}* is a high-grade power carbon emission factor in the raw material acquisition stage, and *E_{iH}* is energy consumption of the *i*-th raw material at high grade.

Power carbon emission factors of different grades are accounted respectively in the transportation stage, production and manufacturing stage, product transportation and delivery stage, product use stage and scrap and recycling stage, and power carbon emissions are accounted according to the power carbon emission factors of different grades in each stage and the carbon emissions in each stage.

In the transportation stage, in response to *Cₜᵣ<C_{trL}*, it is at low-grade carbon emission in the transportation stage, and the low-grade power carbon emission factor in the transportation stage is expressed as:
${EFC}_{trL} = \frac{{\sum }_{j = 1}^{m} \left({E}_{jL}\times {TFC}_{j}\right)}{{\sum }_{j = 1}^{m} {E}_{jL}}$
where, *EFC_{trL}* is the low-grade power carbon emission factor in the transportation stage, and *E_{jL}* is the energy consumption of the *j*-th transportation at low grade; in response to *C_{trL}*<*Cₜᵣ*<*C_{trH},* it is at medium-grade carbon emission in the transportation stage, and the medium-grade power carbon emission factor in the transportation stage is expressed as:
   ${EFC}_{trM} = \frac{{\sum }_{j = 1}^{m} \left({E}_{jM}\times {TFC}_{j}\right)}{{\sum }_{j = 1}^{m} {E}_{jM}}$
where, *EFC_{trM}* is the medium-grade power carbon emission factor in the transportation stage, and *E_{jM}* is the energy consumption of the *j*-th transportation at medium grade; in response to *Cₜᵣ*>*C_{trH},* it is at high-grade carbon emission in the transportation stage, and the high-grade power carbon emission factor in the transportation stage is expressed as:
   ${EFC}_{trH} = \frac{{\sum }_{j = 1}^{m} \left({E}_{jH}\times {TFC}_{j}\right)}{{\sum }_{i = 1}^{m} {E}_{jH}}$
where, *EFC_{trH}* is the high-grade power carbon emission factor in the transportation stage, and *E_{jH}* is the energy consumption of the *j*-th transportation at high grade.

In the production and manufacturing stage, in response to *Cₘₐₙ<C_{manL}*, it is at low-grade carbon emission in the production and manufacturing stage, and the low-grade power carbon emission factor in the production and manufacturing stage is expressed as:
${EFC}_{manL} = \frac{{\sum }_{k = 1}^{l} \left({E}_{kL}\times {EFC}_{en}\right)}{{\sum }_{k = 1}^{l} {E}_{kL}}$
where, *EFC_{manL}* is the low-grade power carbon emission factor in the production and manufacturing stage, and *E_{kL}* is the energy consumption of the *k*-th production link at low grade; in response to *C_{manL}<Cₘₐₙ<C_{manH}*, it is at medium-grade carbon emission in the production and manufacturing stage, and the medium-grade power carbon emission factor in the production and manufacturing stage is expressed as:
   ${EFC}_{manM} = \frac{{\sum }_{k = 1}^{l} \left({E}_{kM}\times {EFC}_{en}\right)}{{\sum }_{k = 1}^{l} {E}_{kM}}$
where *EFC_{manM}* is the medium-grade power carbon emission factor in the production and manufacturing stage, and *E_{kL}* is the energy consumption of the k-th production link at medium grade; in response to *Cₘₐₙ>C_{manH},* it is at high-grade carbon emission in the production and manufacturing stage, and the high-grade power carbon emission factor in the production and manufacturing stage is expressed as:
   ${EFC}_{manH} = \frac{{\sum }_{k = 1}^{l} \left({E}_{kH}\times {EFC}_{en}\right)}{{\sum }_{k = 1}^{l} {E}_{kH}}$
where, *EFC_{manM}* is the high-grade power carbon emission factor in the production and manufacturing stage, and *E_{kL}* is the energy consumption of the k-th production link at high grade.

In the product transportation and delivery stage, in response to *C_{td}*<*C_{tdL}*, it is at low-grade carbon emission in the product transportation and delivery stage, and the low-grade power carbon emission factor in the product transportation and delivery stage is expressed as:
${EFC}_{tdL} = \frac{{E}_{tdL} \times {TFC}_{td}}{{E}_{tdL}}$
where *EFC_{tdL}* is the low-grade power carbon emission factor in the product transportation and delivery stage, and *E_{tdL}* is the energy consumption of product transportation and delivery at low grade; in response to *C_{tdL}*<*C_{td}*<*C_{tdH}* , it is at medium-grade carbon emission in the product transportation and delivery stage, and the medium-grade power carbon emission factor in the product transportation and delivery stage is expressed as:
   ${EFC}_{tdM} = \frac{{E}_{tdM} \times {TFC}_{td}}{{E}_{tdM}}$
where *EFC_{tdM}* is the medium-grade power carbon emission factor in the product transportation and delivery stage, and *E_{tdM}* is the energy consumption of product transportation and delivery at medium grade; in response to *C_{td}*>*C_{tdH}* , it is at high-grade carbon emission in the product transportation and delivery stage, and the high-grade power carbon emission factor in the product transportation and delivery stage is expressed as:
   ${EFC}_{tdH} = \frac{{E}_{tdH} \times {TFC}_{td}}{{E}_{tdH}}$
where *EFC_{tdH}* is the high-grade power carbon emission factor in the product transportation and delivery stage, and *E_{tdH}* is the energy consumption of product transportation and delivery at high grade.

In the product use stage, in response to *Cᵤₛₑ*<*C_{useL}* , it is at low-grade carbon emission in the product use stage, and the low-grade power carbon emission factor in the product use stage is expressed as:
${EFC}_{useL} = \frac{{E}_{useL} \times {EFC}_{en}}{{E}_{useL}}$
where *EFC_{useL}* is the low-grade power carbon emission factor in the product use stage, and *E_{useL}* is the energy consumption of product use at low grade; in response to *C_{useL}*<*Cᵤₛₑ*<*C_{useH}* , it is at medium-grade carbon emission in the product use stage, and the medium-grade power carbon emission factor in the product use stage is expressed as:
   ${EFC}_{useM} = \frac{{E}_{useM} \times {EFC}_{en}}{{E}_{useM}}$
where, *EFC_{useM}* is the medium-grade power carbon emission factor in the product use stage, and *E_{useM}* is the energy consumption of product use at medium grade; in response to *Cᵤₛₑ*>*C_{useH}* , it is at high-grade carbon emission in the product use stage, and the high-grade power carbon emission factor in the product use stage is expressed as:
   ${EFC}_{useH} = \frac{{E}_{useH} \times {EFC}_{en}}{{E}_{useH}}$
where, *EFC_{useH}* is the high-grade power carbon emission factor in the product use stage, and *E_{useH}* is the energy consumption of product use at high grade.

In the scrap and recycling stage, in response to *C_{rec}*<*C_{recL}* , it is at low-grade carbon emission in the scrap and recycling stage, and the low-grade power carbon emission factor in the scrap and recycling stage is expressed as:
${EFC}_{recL} = \frac{{E}_{recL} \times {EFC}_{en} - SC}{{E}_{recL}}$
where, *EFC_{recL}* is the low-grade power carbon emission factor in the scrap and recycling stage, and *E_{recL}* is the energy consumption of scrap and recycling at low grade; in response to *C_{recL}*<*C_{rec}*<*C_{recH}* , it is at medium-grade carbon emission in the scrap and recycling stage, and the medium-grade power carbon emission factor in the scrap and recycling stage is expressed as:
   ${EFC}_{recM} = \frac{{E}_{recM} \times {EFC}_{en} - SC}{{E}_{recM}}$
where, *EFC_{recM}* is the medium-grade power carbon emission factor in the scrap and recycling stage, and *E_{recM}* is the energy consumption of scrap and recycling at medium grade; in response to *C_{rec}*>*C_{recH}* , it is at high-grade carbon emission in the scrap and recycling stage, and the high-grade power carbon emission factor in the scrap and recycling stage is expressed as:
   ${EFC}_{recH} = \frac{{E}_{recH} \times {EFC}_{en} - SC}{{E}_{recH}}$
where, *EFC_{recH}* is the high-grade power carbon emission factor in the scrap and recycling stage, and *E_{recH}* is the energy consumption of scrap and recycling at high grade.

Power carbon emissions are accounted in stages of the raw material acquisition, transportation, production and manufacturing, product transportation and delivery, product use and scrap and recycling according to the power carbon emission factors of each grade in each stage and the carbon emissions in each stage, expressed as:
${CP}_{zx} = {EFC}_{zx} \times {C}_{z}$
where, *CP_{zx}* is the power carbon emissions of grade *x* in stage *z* , *EFC_{zx}* is the power carbon emission factor of grade *x* in stage *z* , and *C_{z}* is the carbon emissions in stage *z* .

In the raw material acquisition stage, in response to it is at low-grade carbon emission in the raw material acquisition stage, the accounted power carbon emissions are expressed as:
${CP}_{rmL} = {EFC}_{rmL} \times {C}_{rm}$
where, *CP_{rmL}* is the accounted power carbon emissions at low-grade carbon emission in the raw material acquisition stage; in response to it is at medium-grade carbon emission in the raw material acquisition stage, the accounted power carbon emissions are expressed as:
   ${CP}_{rmM} = {EFC}_{rmM} \times {C}_{rm}$
where, *CP_{rmM}* is the accounted power carbon emissions at medium-grade carbon emission in the raw material acquisition stage; in response to it is at high-grade carbon emission in the raw material acquisition stage, the accounted power carbon emissions are expressed as:
   ${CP}_{rmH} = {EFC}_{rmH} \times {C}_{rm}$
where, *CP_{rmH}* is the accounted power carbon emissions at high-grade carbon emission in the raw material acquisition stage.

In the transportation stage, in response to it is at low-grade carbon emission in the transportation stage, the accounted power carbon emissions are expressed as:
${CP}_{trL} = {EFC}_{trL} \times {C}_{tr}$
where, *CP_{trL}* is the accounted power carbon emissions at low-grade carbon emission in the transportation stage; in response to it is at medium-grade carbon emission in the transportation stage, the accounted power carbon emissions are expressed as:
   ${CP}_{trM} = {EFC}_{trM} \times {C}_{tr}$
where, *CP_{trL}* is the accounted power carbon emissions at medium-grade carbon emission in the transportation stage; in response to it is at high-grade carbon emission in the transportation stage, the accounted power carbon emissions are expressed as:
   ${CP}_{trH} = {EFC}_{trH} \times {C}_{tr}$
where, *CP_{trH}* is the accounted power carbon emissions at high-grade carbon emission in the transportation stage.

In the production and manufacturing stage, in response to it is at low-grade carbon emission in the production and manufacturing stage, the accounted power carbon emissions are expressed as:
${CP}_{manL} = {EFC}_{manL} \times {C}_{man}$
where, *CP_{manL}* is the accounted power carbon emissions at low-grade carbon emission in the production and manufacturing stage; in response to it is at medium-grade carbon emission in the production and manufacturing stage, the accounted power carbon emissions are expressed as:
   ${CP}_{manM} = {EFC}_{manM} \times {C}_{man}$
where, *CP_{manM}* is the accounted power carbon emissions at medium-grade carbon emission in the production and manufacturing stage; in response to it is at high-grade carbon emission in the production and manufacturing stage, the accounted power carbon emissions are expressed as:
   ${CP}_{manH} = {EFC}_{manH} \times {C}_{man}$
where, *CP_{manH}* is the accounted power carbon emissions at high-grade carbon emission in the production and manufacturing stage.

In the product transportation and delivery stage, in response to it is at low-grade carbon emission in the product transportation and delivery stage, the accounted power carbon emissions are expressed as:
${CP}_{tdL} = {EFC}_{tdL} \times {C}_{td}$
where, *CP_{tdL}* is the accounted power carbon emissions at low-grade carbon emission in the product transportation and delivery stage; in response to it is at medium-grade carbon emission in the product transportation and delivery stage, the accounted power carbon emissions are expressed as:
   ${CP}_{tdM} = {EFC}_{tdM} \times {C}_{td}$
where, *CP_{tdM}* is the accounted power carbon emissions at medium-grade carbon emission in the product transportation and delivery stage; in response to it is at high-grade carbon emission in the product transportation and delivery stage, the accounted power carbon emissions are expressed as:
   ${CP}_{tdH} = {EFC}_{tdH} \times {C}_{td}$
where, *CP_{tdH}* is the accounted power carbon emissions at high-grade carbon emission in the product transportation and delivery stage.

In the product use stage, in response to it is at low-grade carbon emission in the product use stage, the accounted power carbon emissions are expressed as:
${CP}_{useL} = {EFC}_{useL} \times {C}_{use}$
where, *CP_{useL}* is the accounted power carbon emissions at low-grade carbon emission in the product use stage; in response to it is at medium-grade carbon emission in the product use stage, the accounted power carbon emissions are expressed as:
   ${CP}_{useM} = {EFC}_{useM} \times {C}_{use}$
where, *CP_{useM}* is the accounted power carbon emissions at medium-grade carbon emission in the product use stage; in response to it is at high-grade carbon emission in the product use stage, the accounted power carbon emissions are expressed as:
   ${CP}_{useH} = {EFC}_{useH} \times {C}_{use}$
where, *CP_{useH}* is the accounted power carbon emissions at high-grade carbon emission in the product use stage.

In the scrap and recycling stage, in response to it is at low-grade carbon emission in the scrap and recycling stage, the accounted power carbon emissions are expressed as:
${CP}_{recL} = {EFC}_{recL} \times {C}_{rec}$
where, *CP_{recL}* is the accounted power carbon emissions at low-grade carbon emission in the scrap and recycling stage; in response to it is at medium-grade carbon emission in the scrap and recycling stage, the accounted power carbon emissions are expressed as:
   ${CP}_{recM} = {EFC}_{recM} \times {C}_{rec}$
where, *CP_{recM}* is the accounted power carbon emissions at medium-grade carbon emission in the scrap and recycling stage; in response to it is at high-grade carbon emission in the scrap and recycling stage, the accounted power carbon emissions are expressed as:
   ${CP}_{recH} = {EFC}_{recH} \times {C}_{rec}$
where, *CP_{recH}* is the accounted power carbon emissions at high-grade carbon emission in the scrap and recycling stage.

The accounted carbon emissions of all stages are summed up to obtain the carbon footprint accounting of the entire product life cycle, expressed as:
$CP = {\sum }_{z = 1}^{6} {CP}_{zx}$
where, *CP* is the carbon footprint accounting of the entire product life cycle.

In response to that *CP* is lower than the low threshold of carbon footprint accounting of the entire product life cycle, the environmental impact of the product is within the acceptable range or excellent, and the current mode is maintained. In response to that *CP* is between the low threshold and medium threshold of carbon footprint accounting of the entire product life cycle, it indicates that the environmental impact of the product is at a general level, energy use and production process are reviewed, emission reduction potential is identified, and energy efficiency improvement measures are implemented; in response to that *CP* is between the medium threshold and high threshold of carbon footprint accounting of the entire product life cycle, focusing on high-emission activities, formulating specific emission reduction plans, investing in clean energy technologies, improving logistics and supply chain management, and reducing transportation emissions. In response to that *CP* exceeds the high threshold of carbon footprint accounting of the entire product life cycle, the environmental impact of the product is too high, strategic adjustment and improvement are carried out, the product is redesigned, and low-carbon technologies are adopted.

### Second embodiment

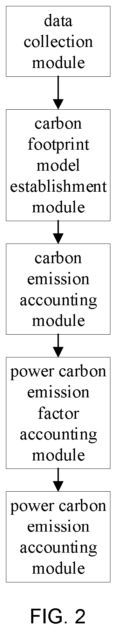

Referring to FIG. 2, which is the second embodiment of the present application. What is different from the previous embodiment in that it provides a carbon footprint accounting system for power grid material product based on LCA, including: a data collection module, a carbon footprint model establishment module, a carbon emission accounting module, a power carbon emission factor accounting module and a power carbon emission accounting module.

The data collection module collects all relevant data for power grid material product, including raw material dosage, composition, transportation distance, energy consumption information, as well as energy consumption and gas emission data during production.

The carbon footprint model establishment module constructs a product carbon footprint model based on the collected data and the life cycle assessment method, covering all stages from raw material acquisition, transportation, production and manufacturing, product transportation and delivery, product use to scrap and recycling.

The carbon emission accounting module accounts carbon emissions in each stage according to the carbon footprint model and the collected data.

The power carbon emission factor accounting module accounts power carbon emission factors of different grades in each stage.

The power carbon emission accounting module accounts power carbon emissions according to the power carbon emission factors of different grades in each stage and the carbon emissions in each stage.

If the functions are implemented in the form of software functional units and sold or used as independent product, they can be stored in a computer-readable storage medium. Based on this understanding, the technical solution of the present application essentially or the part that contributes to the prior art or the part of the technical solution can be embodied in the form of a software product. The computer software product is stored in a storage medium and includes several instructions to enable a computer device (which can be a personal computer, a server, or a network device, etc.) to execute all or part of the steps of the method described in each embodiment of the present application. The storage medium includes: U disk, mobile hard disk, read-only memory (ROM), random access memory (RAM), magnetic disk or optical disk and other media that can store program codes.

The logic and/or steps represented in the flowcharts or otherwise described herein, for example, can be considered as an ordered list of executable instructions for implementing logical functions, can be embodied in any computer-readable medium for use by or in connection with an instruction execution system, apparatus, or device (such as a computer-based system, a system including a processor, or other system that can fetch instructions from an instruction execution system, apparatus, or device and execute instructions). For the purposes of this specification, a "computer-readable medium" can be any medium that can contain, store, communicate, propagate, or transport the program for use by or in connection with the instruction execution system, apparatus, or device.

More specific examples (non-exhaustive list) of computer-readable media include the following: electrical connection with one or more wires (electronic device), portable computer diskette (magnetic device), random access memory (RAM), read-only memory (ROM), erasable programmable read-only memory (EPROM or flash memory), optical fiber device, and portable compact disc read-only memory (CDROM). In addition, the computer-readable medium can even be paper or other suitable medium on which the program can be printed, because the program can be electronically obtained, for example, by scanning the paper or other medium, then edited, interpreted or otherwise processed in a suitable manner if necessary, and then stored in the computer memory.

It should be understood that each part of the present application can be implemented by hardware, software, firmware or a combination thereof. In the above embodiments, multiple steps or methods can be implemented by software or firmware stored in a memory and executed by a suitable instruction execution system. For example, if implemented by hardware, as in another embodiment, it can be implemented by any one or a combination of the following technologies well known in the art: discrete logic circuits with logic gate circuits for realizing logical functions of data signals, application specific integrated circuits with suitable combined logic gate circuits, programmable gate arrays (PGA), field programmable gate arrays (FPGA), etc.

### Third embodiment

The third embodiment of the present application is different from the previous two embodiments in that it is used to verify and illustrate the technical effects adopted in the present application, so as to verify the real effects of the present method.

A number of specific power grid material product are selected for simulation. The simulation time range is set, the same data is input into the two methods, and carbon footprint accounting is carried out using the method of the present application and the traditional method.

In this embodiment, the traditional method and the method of the present application are used for detection at the same time, and the detection comparison results are shown in the following table:

**Table 1: comparison table between traditional method and the method of the present application**

| evaluation index | traditional method | method of the present application |
|---|---|---|
| annual average carbon footprint accounting error rate | 18.9% | 7.2% |
| carbon footprint accuracy improvement rate | 16.7% | 31.8% |
| waste reduction rate | 21.2% | 34.6% |
| energy consumption reduction rate | 10.3% | 15.7% |

It can be seen from the above comparison results that the annual average carbon footprint accounting error rate of the method of the present application is 7.2%, which is 11.7% lower than 18.9% of the traditional method. The carbon footprint accuracy improvement rate is 31.8%, which is 15.1% higher than 16.7% of the traditional method. The waste reduction rate is 34.6%, which is 13.4% higher than 21.2% of the traditional method. The energy consumption reduction rate is 15.7%, which is 5.4% higher than 10.3% of the traditional method.

It should be noted that the above embodiments are only used to illustrate the technical solutions of the present application rather than limit them. Although the present application has been described in detail with reference to embodiments, those skilled in the art should understand that the technical solutions of the present application can be modified or equivalently replaced without departing from the spirit and scope of the technical solutions of the present application, and all of them shall be covered in the scope of the claims of the present application.

## Claims

1. A carbon footprint accounting method for power grid material product based on life cycle assessment (LCA), **characterized by** comprising:
establishing a product carbon footprint model for the power grid material product based on a LCA method;
collecting data for the power grid material product, and accounting carbon emissions for the power grid material product in each stage from raw material acquisition to scrap and recycling according to the collected data;
selecting power carbon emission factors of different grades for each stage in the carbon footprint accounting to account power carbon emissions; and
completing high-precision real-time carbon footprint accounting of an entire life cycle for the power grid material product in combination with the accounted data.

2. The carbon footprint accounting method for the power grid material product based on the LCA according to claim 1, wherein:
the product carbon footprint model comprises stages of raw material acquisition, transportation, production and manufacturing, product transportation and delivery, product use and scrap and recycling; and
the data for the power grid material product comprise raw material dosage, composition, transportation distance, energy consumption information for the power grid material product, and energy consumption and gas emission data during production.

3. The carbon footprint accounting method for the power grid material product based on the LCA according to claim 2, wherein:
the carbon emissions in each stage comprise carbon emissions in the raw material acquisition stage, carbon emissions in the transportation stage, carbon emissions in the production and manufacturing stage, carbon emissions in the product transportation and delivery stage, carbon emissions in the product use stage and carbon emissions in the scrap and recycling stage;
the carbon emissions in the raw material acquisition stage are expressed as: ${C}_{rm} = {\sum }_{i = 1}^{n} \left({Q}_{i}\times {EFC}_{i}+{IP}_{i}\right)$ ${IP}_{i} = {R}_{i} \times {EFC}_{pmi}$
wherein *Cᵣₘ* is the carbon emissions in the raw material acquisition stage, *i* is an *i*-th raw material, *n* is a total type of raw materials, *Qᵢ* is a quantity of the *i*-th raw material, *EFCᵢ* is a direct carbon emission coefficient of the *i*-th raw material, *IPᵢ* is an indirect carbon emission of the *i*-th raw material, *Rᵢ* is energy required for production and processing of the *i*-th raw material, and *EFCₚₘᵢ* is a carbon emission coefficient of energy for production and processing of the *i*-th raw material; and
the carbon emissions in the transportation stage are expressed as: ${C}_{tr} = {\sum }_{j = 1}^{m} \left(\left({D}_{j}\times {TFC}_{j}\times {W}_{j}\right)+{IP}_{trj}\right)$ ${IP}_{trj} = {E}_{trj} \times {EFC}_{trj}$
wherein *Cₜᵣ* is the carbon emissions in the transportation stage, *j* is a *j*-th transportation, *m* is a total number of transportation, *Dⱼ* is a distance of the *j*-th transportation, *TFCⱼ* is a carbon emission coefficient of the *j*-th transportation, *Wⱼ* is a cargo weight of the *j*-th transportation, *IPₜᵣⱼ* is an indirect carbon emission of the *j*-th transportation, *Eₜᵣⱼ* is an energy consumption of the *j*-th transportation, and *EFCₜᵣⱼ* is a carbon emission coefficient of energy for the *j*-th transportation.

4. The carbon footprint accounting method for the power grid material product based on the LCA according to claim 3, wherein:
the carbon emissions in the production and manufacturing stage are expressed as: ${C}_{man} = \left(EC\times {EFC}_{en}\right) + GP + {IP}_{man}$ ${IP}_{man} = {\sum }_{k = 1}^{l} \left({E}_{{pd}_{k}}\times {EFC}_{{pe}_{k}}\right)$
wherein *Cₘₐₙ* is the carbon emissions in the production and manufacturing stage, *EC* is energy consumption during production, *EFCₑₙ* is a carbon emission coefficient of energy used, *GP* is a gas emission during production, *IPₘₐₙ* is an indirect carbon emission during production and manufacturing, *k* is a *k*-th production link, *l* is a total number of production links, *E_{pdₖ}* is energy consumption of the *k* -th production link, and *EFC_{peₖ}* is a carbon emission coefficient of energy for the *k* -th production link;
the carbon emissions in the product transportation and delivery stage are expressed as: ${C}_{td} = {D}_{td} \times {TFC}_{td} \times {W}_{td} + {IP}_{td}$ ${IP}_{td} = {E}_{td} \times {EFC}_{td}$
wherein *C_{td}* is the carbon emissions in the product transportation and delivery stage, *D_{td}* is a transportation distance in the product transportation and delivery stage, *TFC_{td}* is a carbon emission coefficient of a transportation mode, *W_{td}* is a cargo weight, *IP_{td}* is an indirect carbon emission in the product transportation and delivery stage, *E_{td}* is other energy consumption during transportation, and *EFC_{td}* is a carbon emission coefficient of energy for other energy consumption activities;
the carbon emissions in the product use stage are expressed as: ${C}_{use} = \left(EU\times {EFC}_{en}\right) + {IP}_{use}$ ${IP}_{use} = {EU}_{aux} \times {EFC}_{en}$
wherein *Cᵤₛₑ* is the carbon emissions in the product use stage, *EU* is energy consumption during product use, *IPᵤₛₑ* is an indirect carbon emission during use, and *EUₐᵤₓ* is energy consumption of auxiliary equipment during use; and
the carbon emissions in the scrap and recycling stage are expressed as: ${C}_{rec} = \left(\left({ED}_{rec}\times {EFC}_{en}\right)-SC\right) + {IP}_{rec}$ ${IP}_{rec} = \left({E}_{pr}\times {EFC}_{pe}\right) - SR$
wherein *C_{rec}* is the carbon emissions in the scrap and recycling stage, *ED_{rec}* is energy consumption for treatment and transportation, *SC* is carbon emissions saved by recycling materials, *IP_{rec}* is an indirect carbon emission during scrap and recycling,
*Eₚᵣ* is energy consumption for treatment and recycling, *EFCₚₑ* is a carbon emission coefficient of energy for treatment and recycling, and *SR* is carbon emissions reduced by recycling materials.

5. The carbon footprint accounting method for the power grid material product based on the LCA according to claim 4, wherein:
the power carbon emission factors comprise setting low, medium and high grade thresholds in each stage from raw material acquisition to scrap and recycling, and accounting the power carbon emission factors according to different grades;
in the raw material acquisition stage, in response to *Cᵣₘ*<*C_{rmL}*, the raw material acquisition stage is at low-grade carbon emission, and a low-grade power carbon emission factor in the raw material acquisition stage is expressed as: ${EFC}_{rmL} = \frac{{\sum }_{i = 1}^{n} \left({E}_{iL}\times {EFC}_{i}\right)}{{\sum }_{i = 1}^{n} {E}_{iL}}$
wherein *EFC_{rmL}* is a low-grade power carbon emission factor in the raw material acquisition stage, and *E_{iL}* is energy consumption of the *i*-th raw material at low grade;
in response to *C_{rmL}<Cᵣₘ<C_{rmH}*, the raw material acquisition stage is at medium-grade carbon emission, and a medium-grade power carbon emission factor in the raw material acquisition stage is expressed as: ${EFC}_{rmM} = \frac{{\sum }_{i = 1}^{n} \left({E}_{iM}\times {EFC}_{i}\right)}{{\sum }_{i = 1}^{n} {E}_{iM}}$
wherein *EFC_{rmM}* is a medium-grade power carbon emission factor in the raw material acquisition stage, and *E_{iM}* is the energy consumption of the *i*-th raw material at medium grade;
in response to *Cᵣₘ*>*C_{rmH}*, the raw material acquisition stage is at high-grade carbon emission, and a high-grade power carbon emission factor in the raw material acquisition stage is expressed as: ${EFC}_{rmH} = \frac{{\sum }_{i = 1}^{n} \left({E}_{iH}\times {EFC}_{i}\right)}{{\sum }_{i = 1}^{n} {E}_{iH}}$
wherein *EFC_{rmH}* is a high-grade power carbon emission factor in the raw material acquisition stage, and *E_{iH}* is energy consumption of the *i*-th raw material at high grade; and
power carbon emission factors of different grades are accounted respectively in the transportation stage, production and manufacturing stage, product transportation and delivery stage, product use stage and scrap and recycling stage, and power carbon emissions are accounted according to the power carbon emission factors of different grades in each stage and the carbon emissions in each stage.

6. The carbon footprint accounting method for the power grid material product based on the LCA according to claim 5, wherein:
the accounting of power carbon emissions comprises accounting power carbon emissions in the stages of raw material acquisition, transportation, production and manufacturing, product transportation and delivery, product use and scrap and recycling according to the power carbon emission factors of each grade in each stage and the carbon emissions in each stage, and the power carbon emission is expressed as: ${CP}_{zx} = {EFC}_{zx} \times {C}_{z}$
wherein *CP_{zx}* is power carbon emissions of grade *x* in stage *z* , *EFC_{zx}* is a power carbon emission factor of grade *x* in stage *z* , and *C_{z}* is carbon emissions in stage *z* .

7. The carbon footprint accounting method for the power grid material product based on the LCA according to claim 6, wherein:
the high-precision real-time carbon footprint accounting of the entire life cycle comprises summing up the accounted carbon emissions of all stages to obtain the carbon footprint accounting of the entire product life cycle, and the carbon footprint accounting is expressed as: $CP = {\sum }_{z = 1}^{6} {CP}_{zx}$
wherein *CP* is the carbon footprint accounting of the entire product life cycle;
in response to that *CP* is lower than a low threshold of the carbon footprint accounting of the entire product life cycle, an environmental impact of the product being within an acceptable range or excellent, and maintaining a current mode;
in response to that *CP* is between the low threshold and medium threshold of carbon footprint accounting of the entire product life cycle, the environmental impact of the product being at a general level, reviewing energy use and production process, identifying emission reduction potential, and implementing energy efficiency improvement measures;
in response to that *CP* is between the medium threshold and high threshold of the carbon footprint accounting of the entire product life cycle, focusing on high-emission activities, formulating specific emission reduction plans, investing in clean energy technologies, improving logistics and supply chain management, and reducing transportation emissions; and
in response to that *CP* exceeds the high threshold of carbon footprint accounting of the entire product life cycle, the environmental impact of the product being too high, carrying out strategic adjustment and improvement, redesigning the product, and adopting low-carbon technologies.

8. A system adopting the carbon footprint accounting method for the power grid material product based on the LCA according to any one of claims 1 to 7, **characterized by** comprising: a data collection module, a carbon footprint model establishment module, a carbon emission accounting module, a power carbon emission factor accounting module and a power carbon emission accounting module; wherein
the data collection module is configured to collect all relevant data for the power grid material product, and the relevant data comprises raw material dosage, composition, transportation distance, energy consumption information, and energy consumption and gas emission data during production;
the carbon footprint model establishment module is configured to construct a product carbon footprint model based on the collected data and the LCA method, wherein the product carbon footprint model covers all stages from raw material acquisition, transportation, production and manufacturing, product transportation and delivery, product use to scrap and recycling;
the carbon emission accounting module is configured to account carbon emissions in each stage according to the carbon footprint model and the collected data;
the power carbon emission factor accounting module is configured to account power carbon emission factors of different grades in each stage; and
the power carbon emission accounting module is configured to account power carbon emissions according to the power carbon emission factors of different grades in each stage and the carbon emissions in each stage.

9. A computer device, comprising a memory and a processor, wherein the memory stores a computer program, **characterized in that** the processor implements the steps of the carbon footprint accounting method for the power grid material product based on the LCA according to any one of claims 1 to 7 when executing the computer program.

10. A computer-readable storage medium storing a computer program, **characterized in that** the computer program implements the steps of the carbon footprint accounting method for the power grid material product based on the LCA according to any one of claims 1 to 7 when executed by a processor.
